# EUROPEAN PATENT APPLICATION

(11) **EP 0 525 217 A1**
(43) Date of publication of application: **03.02.1993**
(21) Application number: 91111737.2
(22) Date of filing: 15.07.1991
(51) Int. Cl.: H05K 7/06

(54) **Carrier for electronic components**

(71) Applicant: International Business Machines Corporation, Armonk, N.Y. 10504 (US)
(72) Inventor: Auber, Roland, W-7032 Sindelfingen (DE); Deegen, Axel, Dipl.-Ing., W-7033 Herrenberg (DE); Frick, Helmut, Dipl.-Ing., W-7046 Gäufelden 1 (DE); Gruber, Harald W., W-7033 Herrenberg (DE); Horbach, Heinz-G., Dipl.-Ing., W-7268 Gechingen (DE); Stadler, Ewald E., Dipl.-Ing., W-7033 Herrenberg (DE)
(74) Representative: Mönig, Anton, Dipl.-Ing.

(57) **Abstract**

₅n7 A carrier on which electronic components (14) and electrical circuits (18, 20) are mounted and connected. The carrier comprises a wire mesh or web (8) which is used as a basic material for a number of applications. For organically or inorganically wires, electrically conductive material or super conducting fibers may be used. The wires may be fabricated as a web or an X/Y layer. The chip can be directly mounted on a mesh of insulated conductive wires. This eliminates one complete packaging level (module) and replaces the complex printed circuit card/board by a simple wire mesh. Personalized X/Y wiring for signals and voltage is accomplished by interconnecting the wire crossings (22) as required and by deleting stubs. Depending upon the diameter of the wires used, more than one wire may be required for providing sufficient power to the chip. The mesh may be assembled on a stiffener with tabs to interconnect with other components or be used directly as a cable. Chip-to-wire interconnection are obtained by removing the insulation and by soldering the chip to the wire. The web may also be fixed to a board or by an appropriate frame. Further disclosed is a method for manufacturing the new carrier and a system comprising the carrier.

In addition to affording high-quality components, alternative manufacturing techniques allow using the advantages of CIM (Computer Integrated Manufacturing), CFM (Continuous Flow Manufacturing), TAT (Tape Auto Testing), lot size = 1, and ECs (engineering changes)/repairs. CFM and TAT concepts are realized by reducing the manufacturing steps to about one third the number presently needed. In addition, most steps are not as complicated and expensive as the classical ones used to produce printed circuit boards.

## Description

The present invention relates to a novel carrier concept on which electronic components and electrical circuits are mounted. Further described is a method for manufacturing the new carrier and an electronic system comprising the carrier.

A printed circuit board (PCB) is a composite of organic and inorganic materials with external and internal wiring, allowing electronic components to be mechanically supported and electrically connected. The term card is used in the industry; this refers to the same technology as a board except that it is smaller in size, has fewer layers and sometimes has coarser dimensions than boards. Thus, the terms board or card are used as synonyms concerning this invention. Except for a small volume of injection molded boards, and metal-core boards, basic materials of printed circuits are copper foil clad laminates. The predominant organic insulations are phenolic-paper, epoxy-glass and polyimide-glass, and a variety of other special polymers. When the components contain only several I/O leads (input and output leads as contrasted to voltage references and power), and only a few were interconnected, one layer of printed-circuit pattern containing a few centimeters of copper interconnection is sufficient. Today the basic functions are the same; the interconnecting copper signal lines join two I/O leads from two different components. The components may be resistors, capacitors, inductors, or semiconductor chips on a first-level package, which are joined electrically to the circuit board. However, the number of I/O leads per component varies over the range from a few to several hundreds for typical applications, and in leading-edge technologies, like multichip modules, to several thousands. There may be hundreds of components attached to an individual circuit board. The required interconnection length is a function of the product of leads per component, number of components, and an average length of interconnection between components. In some cases, when multichip modules which require very long interconnections between them, or when many high I/O components are used, kilometers of printed wiring are required in a printed-circuit board.

Multilayer board manufacture is a very expensive process which needs a multiple of steps consuming a lot of material, chemicals, energy and area. For multilayer products as well as non-internal plane products raw cores are being used to function as an isolator between top and bottom circuits consisting of insulating material e.g. paper, plastic or prepreg (a combination of glasscloth and epoxy). A high and consistent dielectricum is wanted for the function, design and manufacturing of a panel or board. These isolating materials are being laminated with top and/or bottom copper layers of desired thickness and is now ready for circuitization. For the personalization of a printed circuit board the copper layers are circuitizes either by subtractive or additive circuitization as necessary which includes pre-cleaning, application of photo resist, exposure, resist development, copper etching, resist stripping and testing. A next general step of the process comprises the surface preparation with chloride, the lamination of a panel with completed core panels, and providing the drilled holes with several cleaning steps. In case of a multilayer product several prefabricated circuitries are pressed together with the help of pressure and heat, using an isolating material in between, so that a stiff and heavy board will be the result, able to serve several thousands of connections after final processing. Subsequently the laminated layers (which can be more than 30), also named composite, together with the later attached outer circuitries have to be electrically interconnected. This is being done by drilling either throughholes or blind holes at predefined locations. The number and diameter of the holes depends on the circuitry design and will vary from part to part. Each hole must exactly hit the line of each inner plane, which it has to interconnect after the next process step has been performed. After drilling, connections between the holes of different layers will be established. A combination of chemical and galvano process copper is being placed inside of each throughhole or blind hole and on the outer copper layers. Also a steady control of the whole process to stay within the specification of the copper plating thickness over the total surface is very important for the required product performance. Finally the external circuitization is accomplished as usual, and testing, protecting, milling, and providing contacts and housings completes the printed circuit board according to the respective application.

To reduce the expense for manufacturing these boards many proposals have been made. EP-A-228 017 describes the use of a net of covar, molybdenum, invar or wolfram, optionally provided with a copper coating, as a ground plane, a power plane and/or as a layer reducing the thermal expansion of a printed circuit board, preferably a multilayer board with a coefficient of thermal expansion of 5 - 9 ppm/° C. This net solves problems with different coefficients of thermal expansion of the surface mounted ceramic components and the printed circuit board. The net can be coated with a partially cured resin such as phenolic resin, epoxy resin or polyimide and can then be compared with so-called prepregs of paper or glass cloth impregnated with the corresponding type of resin. One or more such coated nets together with suitable number of sheets of epoxy resin impregnated glass cloth and copper foil sheets were pressed at high pressure and elevated temperature thus forming a laminate intended for the production of printed circuit boards with the desired coefficient of thermal expansion. At the pressing the final curing of the resin was obtained in the usual way.

Substrates comprising printed circuit conductor patterns and wire scribed conductors suitable for supporting and interconnecting components are disclosed in EP-B-214 628.

US-A-4 907 127 relates to a printed circuit board comprising a board having front and rear sides, each side being provided thereon with a mesh-like conductor pattern consisting of two crossing sets of plural parallel metal conductor traces. The respective sets of conductor traces on the front and rear side corresponding with one another, wherein a through hole passing through said board from the front to the rear side thereof is provided at every second crossing point of the conductor traces in each direction of the conductor traces on each side of the board. Each hole being plated on its inside edge and the plating of each hole being connected with the respective crossing conductor traces at its respective location on both the front and rear sides of the board. The holes conductively connect the respective crossing conductors on the front and rear sides of the board to one another. The conductor traces are selectively severable on each side of the board for isolating selected holes from their respective crossing conductor traces.

US-A-3 378 629 shows a woven matrix comprising both conducting and insulating warp members and conducting and insulating fill members in which the conductive fill members are woven into direct contact with each other at nodal points spaced apart at predetermined locations on the fabric. The woven matrix is to connect compounds being placed outside the matrix.

US-A-3 711 627 discloses a device for electrical connection of components of electric and electronic circuits consisting of a two-coordinate communication matrix comprising insulating threads woven in two coordinates and non-insulating parallel current conductors. At least two of the current conductors form one current line. All of the current lines are divided into two groups, each corresponding to one coordinate and having parallel current lines, the insulating threads and the current lines are interlaced and have the form of a cloth with nodes of electric contacts. The nodes of electric contacts are formed by weaving the current conductors of the current lines relating to different groups the adjacent conductors in the same line being interlaced with the lines of the other coordinate at each node so as to alternate in their weaveing pattern with one conductor passing over and under the lines of the conductors of the other coordinate whereas the adjacent conductor of the same current line passes under and over the conductors of the other coordinate.

In US-A-4 779 340 a programmable electronic interconnect system is described using a carrier board having electronic circuit components mounted thereon which are conductively connected to carrier board connectors which are in turn interconnected to an interconnect board. The interconnect board has a plurality of first conductors and second conductors that are separated and positioned to intersect to form a plurality of intersections. The first and second conductors may be selectively placed into conductive contact at selected intersect points to thereby form a desired electronic circuit. The interconnect board specifically includes a deformable material between the first and second conductors which are conductively connectable alternately and selectively through the imposition of pressure and temperature.

WO-A-8900374 relates to a method for manufacturing a circuit board on which electronic components and electrical circuits are to be mounted and connected together. The method comprises positioning mutually insulated and mutually intersecting electrical conductors in a layer of substrate material, preferably to form an x/y matrix, and treating the substrate material, with the conductors embedded therein, in a manner to establish interruptions in the various conductor paths at given locations therein, and to establish permanent electrical contact between the intersecting conductor paths at given locations of intersection. The substrate material used is sensitive to a given kind of radiation, and the material is irradiated, while screening those locations at which interruptions are to be established or at which the conductor paths are to be connected together. The material in the non-irradiated locations is then chemically removed, in order to expose the conductors at these locations, whereupon the exposed conductor paths are personalized by etching at those locations where interruptions are desired and the conductor paths are mutually connected at the intersecting locations where electrical contact is desired, by soldering or metal plating techniques.

The object of the present invention is to provide a device for electrical connection of electronic components which is simple in manufacturing and allows easily the change of the wiring for adaptation to specific requirements.

The invention as claimed solves this problem by providing a carrier for electronic components comprising a web of interlaced insulated conductors and means for mechanically stabilizing said web. The web is adapted to carry at least one electronic component, e.g. a chip, and to provide at least one electrical conductive path comprising at least one noninsulated conductor intersection point from which not used conductors are isolated between the electronic component and external terminals or between several electronic components.

The carrier on which electronic components and electrical circuits are directly mounted and connected comprises a web or a wire mesh which is used as a basic material for a number of applications. For organically or inorganically wires, electrically conductive material may be used. The wires may be fabricated as a web or an X/Y layer. The dimensions of such a wire mesh depend on the respective application and may be customized to the required density, a maximum of 625 wires per 25.4mm being normally employed for screen coating. The wire diameter may be adapted to the required physical data of an electrical net and to the insulation thickness and can have a thickness about 10 to 15 micron. The distance between two of the conductors is preferably less than 20 micron.

Such a web used for wire insulation yields uniform and accurate thicknesses and allows a quality-controlled manufacturing cycle similar to that used by the textile web technique. Existing technology standards guarantee a high degree of quality and permit a wide range of applications for webs thus manufactured.

The web is available on rolls or in sheet form with the desired outer dimensions or may be cut to size by the customer or even be tailored to suit particular circuits with integrated connecting cables.

Tailoring may precede or follow programmable circuitization or personalization. The conductor web with its large number of usable intersections is converted into discrete circuitry by connecting intersections and deleting wires not needed for a particular electrical path which can be connected with other paths to a net of conductors.

The chip can be directly mounted on a mesh of insulated conductive wires. This eliminates one complete packaging level (module) and replaces the complex printed circuit card/board by a simple wire mesh. Personalized X/Y wiring for signals and voltage is accomplished by interconnecting the wire crossings as required and by deleting stubs. The respective ends of the not used conductor is then in alignment with the next conductor being in cross arrangement relative to the conductor.

Chip-to-wire and wire-to-wire interconnection are obtained by removing the insulation and by soldering the chip to the wire or the wires at the interconnection point together, respectively.

Depending upon the diameter of the wires used, more than one wire may be required for providing sufficient power to the chip. Thus, the contact pads of at least one electronic component, preferably an integrated circuit chip, are fixed and in electrical contact to at least one respective allied conductor.

The mesh may be assembled on a stiffener with tabs to interconnect with other components or be used directly as a cable. When used as a cable at least a part of said web forms flexible connector means to external terminal means, which may be a plug connector for insertion in a respective socket, for example a zero in force connector assembly. If appropriate a stack of meshes might be used.

The web may also be fixed to a plate or by an appropriate frame for mechanical stabilization. The frame forming stabilizing means may surround said component carrying web and may be made of an insulating material. An other stabilizing means may comprise a base plate made of an electrical insulating and mechanical rigid material fixed to the bottom side of said web. It is not necessary that the base plate carries additional wirings. Base plate or frame may be fixed to the web by glueing. The thickness of a frame or base plate with one web may be about 6 mm.

Another kind of stabilization means with additional advantages is a printed circuit card or board to which the at least on component carrying web is electrically connected. The web serves then as a connector from tabs on the card to the components fixed on the web. The components in this case may be carried on the top and/or bottom side of the web. Usually the webs which make use of this kind of stabilization means are smaller in extent than the webs used for carriers comprising a frame of a base plate because the web in the latter case serves for carrying all the components which are commonly fixed on a printed circuit board whereas the smaller webs only serve for connecting components to a printed circuit card or a carrier which comprises common wiring, e.g. a ceramic or silicon carrier.

For manufacturing the carriers the fabrics or webs is fixed to a stabilizing means, e.g. a frame, and subsequent the insulation of the conductors is removed in accordance with the footprint of the electronic components which shall be packed on the carrier and is removed at interconnection points of the conductor in accordance with the connection path between the components and between the components and external terminals. Preferably, the removal of the insulation and the bonding of the conductors as well as the bonding of the electronic components to the exposed conductors may be performed by a laser scanner well-known in the art. Further the interconnection points are isolated from conductors in the region of the interconnection points which are not used for the connection path by removing parts of the not used conductors, also preferably with a laser.

In addition to affording high-quality components, alternative manufacturing techniques allow using the advantages of CIM (Computer Integrated Manufacturing), CFM (Continuous Flow Manufacturing), TAT (Tape Auto Testing), lot size = 1, and ECs (engineering changes)/repairs. CFM and TAT concepts are realized by reducing the manufacturing steps to about one third the number presently needed. In addition, most steps are not as complicated and expensive as the classical ones used to produce printed circuit boards.

As mentioned above a laser scanner may be used to weld intersections, cut wires not used, and remove insulation material. The laser technique is suitable for lot sizes = 1 and for ECs/repairs, where needed. Presently, microcoils made of insulated wires are welded by lasers. The laser means may be equipment currently available on the market or IBM-developed equipment. Laser pulse trains (which remove insulation material, weld and cut off wires not needed) allow fast and economical welding or cutting (some hundred spots per second).

Microspot welding, as presently employed, is yet another alternative. The electrodes required for this purpose have to be suitably tailored. The pressure of the electrodes must be such as to overcome the mechanical strength of the wire insulation material.

One way of removing the insulation material along the web edges is to place two electrodes next to the wire and to use high voltage arcing, causing the insulation to melt.

"Overflow" wires may be repaired by specially made microconnectors/ disconnectors. Different headforms may be employed for different users (overflow wires, solder platform, etc.) or for establishing electrical connection at a crosspoint. A wedge-shaped part of an insulating material may be used to disconnect or interrupt lines.

At least one carrier according to the invention on which integrated circuit chips are fixed to and electrically connected by said conductors forms together with other essential elements which are usually used and necessary for an electronic system and well known to a person skilled in the art an electronic system. Especially when using a frame as stabilizing means the cooling can be simplified by providing a stream of air through the fabrics.

The present invention is a solution for a high integration in the chip level which cannot be offered by the common wire and printed circuit techniques. By utilization common products of very fine and precise fabricated meshes or webs with the electrical parameters wanted in such manner, that the inputs are connected to the needed outputs by connecting and deleting the picked wires of that web by means of a process which establishes contacts of the intersections of the picked wires and delete the redundant ends. Such manufacturing will allow mass production as well as prototype application with excellent response time from first design to shipped product. Various application techniques are possible and the whole production cycle will be reduced tremendously in comparison with printed circuits.

Further advantages of the invention besides others are the low dielectric constant, no mismatch between the thermal constants, improvements in cooling, increased density and layer reduction, direct chip attachment, and low cost manufacture with less process steps, less resources and material.

For a better understanding of the present invention, together with further objects and advantages, preferred embodiments of the invention are described in the following with reference to the accompanying drawings, in which:
Fig. 1 shows a section of a web of conductors;
Fig. 2 presents a carrier according to the invention with a base plate;
Fig. 3 presents a carrier according to the invention with a frame;
Fig. 4 discloses an enlarged detail view of the component and one conductor;
Fig. 5 is a web with tailored circuitization; and
Fig. 6 is a cross sectional view of a printed circuit card having a carrier fixed on one side.

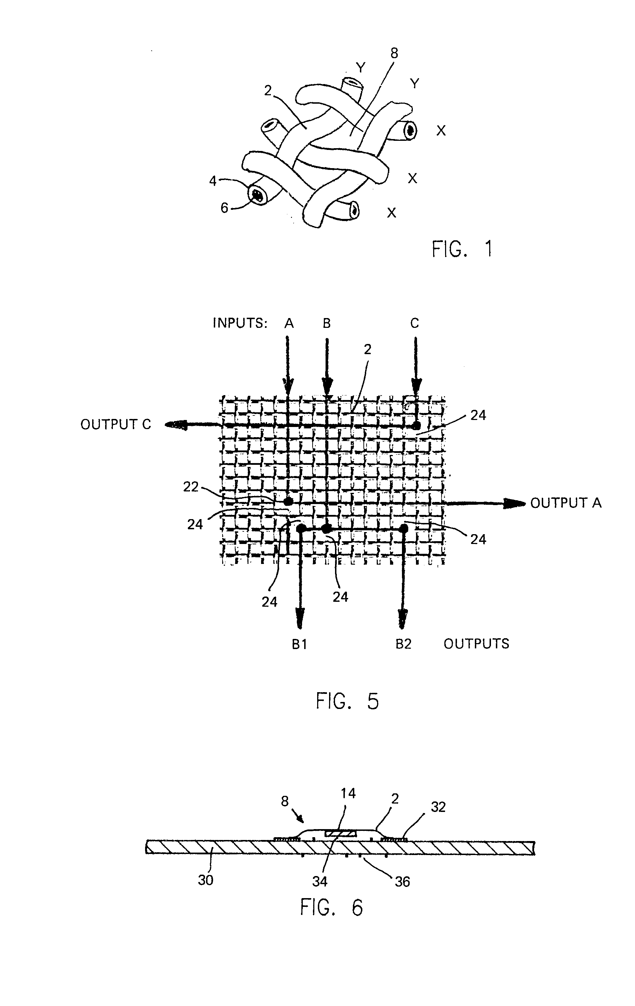

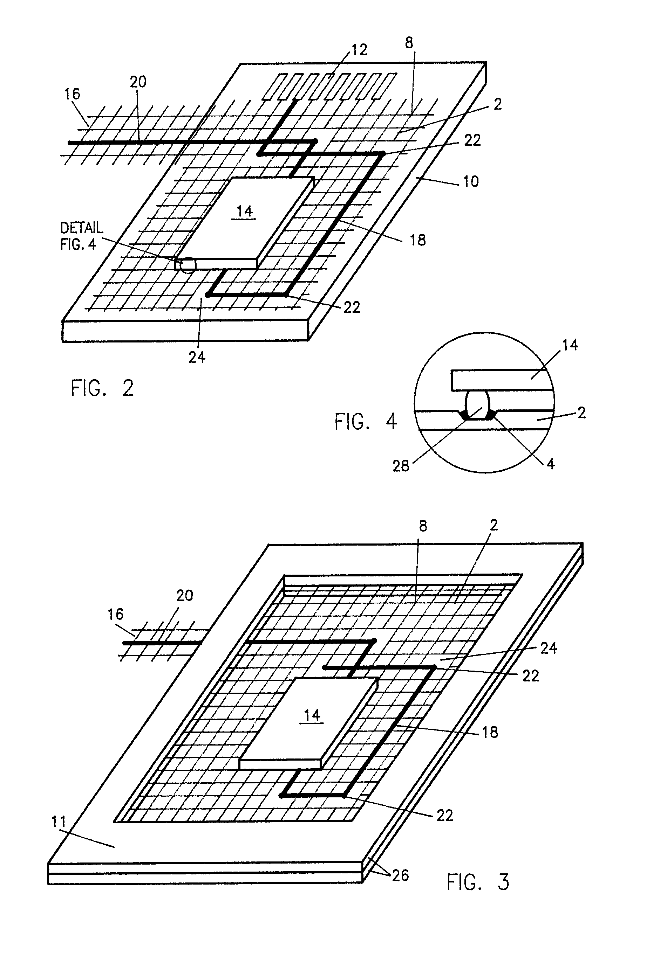

Figure 1 depicts a fabrics 8 of interlaced insulated conductors 2 comprising a insulation 4 around a wire 6. The conductors are arranged in an X-Y-matrix. This web 8 is stabilized in Figure 2 by a base plate 10 having tabs 12 for connecting the web with other devices. The tabs 12 can be used for a connector in which the carrier is inserted. The web is shown in the Figures enlarged relative to the base plate or components 14. A flexible connector or cable 16 for external connections by a plug connector (not shown) is also established by a part of the web 8. Directly fixed on the web is a component 14 which is connected by an conductive path 18 to one of the tabs 12 and by an conductive path 20 via the cable 16 to a plug connector. For simplification purposes only two paths are shown. In reality a plurality of paths 18, 20, tabs 12 and components 14 will be arranged on a carrier according to the invention. The conductive path 18 and 20 comprises interconnection points 22 which connect the wire of one direction to a wire of the other direction of the X-Y-matrix. It is not necessary that the conductors 2 are parallel to the edge of the base plate 10 or the frame 11 (Fig. 3); they can also have an angle of 45 degree or any other to the edges. In this case the paths 18 or 20 might need more than two interconnection points 22. The conductors stubs 24 in the region of the interconnection points 22 which are not used for the respective path are deleted to provide a insulation between the path and the interconnection net.

In Figure 3 a frame 11 as stabilizing means is shown which comprises two layers 26 which clamps the fabric or lead as cable to a conductor (not shown). The frame 11 may also comprise tabs 12 (not shown) which are shown in Fig. 2 as parallel input/output means. This is only for presentation purposes because it might be appropriate to use only one kind of input/output means. The detail in Figure 4 shows the component 14 connected to a conductor 2 with removed insulation 4 at the interconnection point with the solder ball 28 of the component. All the connections are accomplished with a laser.

In Figure 5 a net of conduction paths is shown which connect the inputs with the respective arrows A, B, and C to the respective outputs A, B1 and B2, and C via conductors 2 and interconnection points 22. The interconnection belonging to the path B has only one stub 24 deletion while the orthogonally connected wire has two. This figure shows that the net can be adapted to any desired wiring configuration.

Fig. 6 shows another carrier embodiment in which the stabilizing means are accomplished by a printed circuit card 30 with wiring 36 of which only a part is shown. The card 30 comprises contact pads 32 to which conductors 2 of the web 8 are connected. The web carries a electronic component 14 which is also connected to the respective conductors of the web. The connection between the pads 32 and the chip 14 is accomplished as described above. As shown in figure the electronic component 14 is fixed to the bottom side of the web thereby providing an air gap 34 between the card and the component. It is also possible to fix the component to the card or to provide a further component on the top side of the web. This solution substitutes the well-known method of wire bonding or tape automated bonding.

## Claims

1. Carrier for electronic components comprising
a web (8) of interlaced insulated conductors (2),
means (10, 11, 30) for mechanically stabilizing said fabrics,
wherein said web is adapted to carry at least one electronic component (14) and to provide at least one electrical conductive path (18, 20) comprising at least one noninsulated conductor intersection point (22) from which not used conductors are isolated between said electronic component and external terminals (12) or between several electronic components.

2. Carrier according to claim 1, wherein at least a part of said web forms flexible connector means (16) to external terminal means, preferably a plug connector.

3. Carrier according to claim 1 or 2, wherein the respective conductor ends (24) of said not used conductors are in alignment with the next conductor being in a cross arrangement relative to said conductor.

4. Carrier according to any one of the preceding claims, comprising at least one electronic component, preferably an integrated circuit chip, which contact pads are fixed and in electrical contact to at least one respective allied conductor.

5. Carrier according to any one of the preceding claims, wherein said conductors have a thickness about 10 to 15 micron.

6. Carrier according to any one of the preceding claims, wherein the distance between two of said conductors is less than 20 micron.

7. Carrier according to any one of the preceding claims, wherein said stabilizing means comprise a frame (11) surrounding said component carrying web.

8. Carrier according to any one of the preceding claims, wherein said stabilizing means comprise a base plate (10) fixed to the bottom side of said web.

9. Carrier according to any one of the preceding claims 1 to 6, wherein said stabilizing means comprise a printed circuit card (30) with contact pads (32) to which said web is connected.

10. Method for making a carrier for electronic components, said method comprises
a) providing a web (8) in form of a two-coordinate matrix of interlaced insulated conductors (2);
b) providing means for stabilizing said web and being fixed thereto;
c) laser removing the insulation of the conductors in accordance with the footprint of the electronic components which shall be packed on said carrier;
d) laser removing the insulation at interconnection points of the conductors in accordance with the connection path between said components and between said components and external terminals;
e) isolating of said interconnection points from conductors in the region of the interconnection points which are not used for the connection path by removing parts of the not used conductors with a laser.

11. Method according to claim 10, wherein step c) comprises bonding the contact pads of said electronic component to said exposed conductor, preferably by use of a laser.

12. Method according to claim 10 or 11, wherein step d) comprises bonding said conductors at said interconnection point, preferably by use of a laser.

13. Method according to any one of the preceding claims 10 to 12, wherein remaining stubs of step e) are removed up to the next intersection point, preferably by use of a laser.

14. Method according to any one of the preceding claims 10 to 13, wherein a frame is fixed around said web, preferably by glueing.

15. Method according to any one of the preceding claims 10 to 13, wherein a base plate is fixed to the opposite, not electronic components carrying side, preferably by glueing.

16. An electronic system, preferably a data processing system, comprising at least one carrier according to any one of the preceding claims, wherein integrated circuit chips are fixed to and electrically connected by said conductors.

17. System according to claim 16, further comprising air cooling means for providing a stream of air through the fabrics.
